Europäisches Patentamt

European Patent Office

Office européen des brevets

(11) Publication number: **0 250 675 B1**

# EUROPEAN PATENT SPECIFICATION

(45) Date of publication of patent specification: **21.10.92**　(51) Int. Cl.5: **H01F 7/06**, G01R 33/42

(21) Application number: **86306089.3**

(22) Date of filing: **06.08.86**

The file contains technical information submitted
after the application was filed and not included in
this specification

(54) **Superconducting magnet.**

(30) Priority: **04.06.86 US 870376**

(43) Date of publication of application:
**07.01.88 Bulletin 88/01**

(45) Publication of the grant of the patent:
**21.10.92 Bulletin 92/43**

(84) Designated Contracting States:
**DE GB NL**

(56) References cited:
**EP-A- 0 111 218
GB-A- 1 173 965
GB-A- 1 324 402
US-A- 4 484 814**

**Clarendon Press Oxford, 1983 M.N. Wilson
"Superconducting magnets", pages 7,
251-253**

(73) Proprietor: **MITSUBISHI DENKI KABUSHIKI
KAISHA
2-3, Marunouchi 2-chome Chiyoda-ku
Tokyo 100(JP)**

(72) Inventor: **Saitou, Yosio
c/o Ako Works Mitsubishi Denki Kabushiki
Kaisha
651, Tenwa Ako City Hyogo Prefecture(JP)**
Inventor: **Kataoka, Takeshi
c/o Ako Works Mitsubishi Denki Kabushiki
Kaisha
651, Tenwa Ako City Hyogo Prefecture(JP)**
Inventor: **Takechi, Moriaki
c/o Ako Works Mitsubishi Denki Kabushiki
Kaisha
651, Tenwa Ako City Hyogo Prefecture(JP)**
Inventor: **Matsumoto, Takahiro
c/o Ako Works Mitsubishi Denki Kabushiki
Kaisha
651, Tenwa Ako City Hyogo Prefecture(JP)**

(74) Representative: **Lawson, David Glynne et al
MARKS & CLERK 57-60 Lincoln's Inn Fields
London WC2A 3LS(GB)**

Note: Within nine months from the publication of the mention of the grant of the European patent, any person
may give notice to the European Patent Office of opposition to the European patent granted. Notice of opposition
shall be filed in a written reasoned statement. It shall not be deemed to have been filed until the opposition fee
has been paid (Art. 99(1) European patent convention).

## Description

Background of the Invention:

This invention relates to a superconducting magnet, and more particularly to a vacuum heat insulation vessel which receives the superconducting coil of a superconducting magnet.

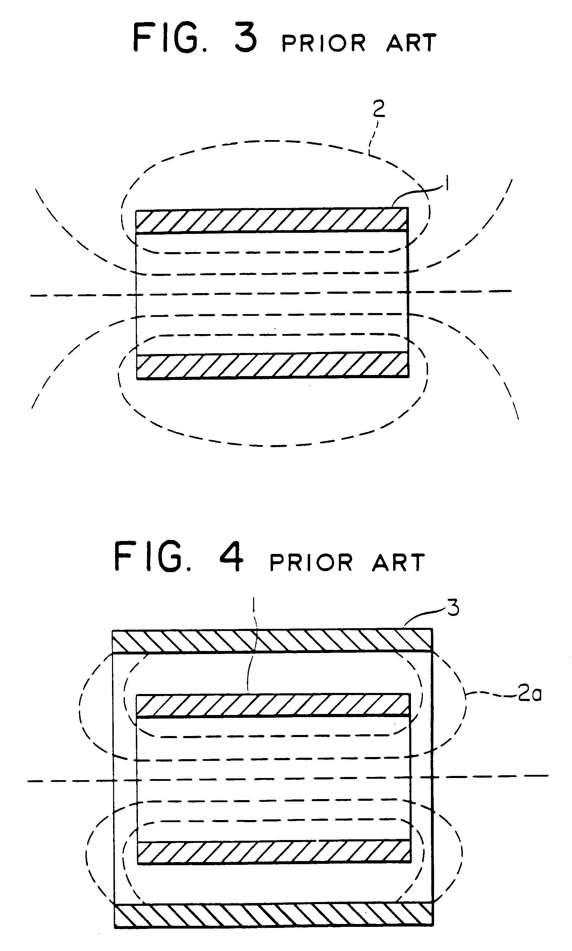

Fig. 3 shows a sectional view of a prior-art magnet. In Fig. 3, numeral 1 designates a coil which generates a magnetic field 2 when a current flows through the winding thereof. In general, a magnet whose coil is small generates a weak magnetic field and is often used without providing a magnetic shield as shown in Fig. 3, since the magnetic field exerts little influence on the surroundings. Fig. 4 shows a sectional view of another example. In Fig. 4, numeral 1 designates a coil by which magnetic fluxes 2a are generated. Numeral 3 designates a magnetic shield which is made of a ferromagnetic substance.

As shown in Fig. 4, in a case where the coil has a large geometry or establishes an intense magnetic field, the magnetic shield made of the ferromagnetic substance is employed for the purpose of preventing the influence of the magnetic field on the surroundings (for example, influence on a magnetic disc for a computer installed nearby).

The prior-art magnets are constructed as shown in Figs. 3 and 4. In the magnet of Fig. 3, the magnetic fluxes 2 interlinking with the coil 1 are generated by energizing the coil. Most of the magnetix fluxes 2 extend along the inner periphery of the coil 1, and some of them traverse the coil 1, to pass through the interior of the coil 1, whereupon the magnetic fluxes 2 extend outside the outer periphery of the coil 1 and enter the interior of the coil 1. Thus, the magnetic fluxes depict loops. On this occasion, the magnetic fluxes extending outside the outer periphery of the coil 1 spread spaciously, and a region which has an intense magnetic field becomes large. Accordingly, when the magnetic disk device or the like of a computer or the like, which is susceptible to a magnetic field, is located in the vicinity of this intense magnetic field, it malfunction may arise.

In the magnet of Fig. 4, the magnetic fluxes 2a interlinking with the coil are generated by energizing the coil 1 as in the case of Fig. 3. In this magnet, since the magnetic shield 3 made of the ferromagnetic substance of high permeability is disposed outside the outer periphery of the coil 1 as shown in Fig. 4, most of the magnetic fluxes 2a generated by the coil 1 are contained inside the magnetic shield 3, and the magnetic fluxes which pass outside the magnetic shield 3 lessen to narrow the region having an intense magnetic field. Accordingly, even when equipment liable to be influenced by a magnetic field is installed near the magnet, it is not influenced thereby.

In this regard, a superconducting magnet is received in a vacuum heat insulation vessel. Therefore, when the magnetic shield of the type described above is applied to the superconducting magnet, it needs to be disposed around the outer periphery of the vacuum heat insulation vessel, resulting in the problem that the geometry of the superconducting magnet enlarges. Another problem is that the double vessel structure consisting of the magnetic shield and the vacuum heat insulation vessel is uneconomical.

A solution to this problem has therefore been proposed in e.g. EP-A-0 111 218.

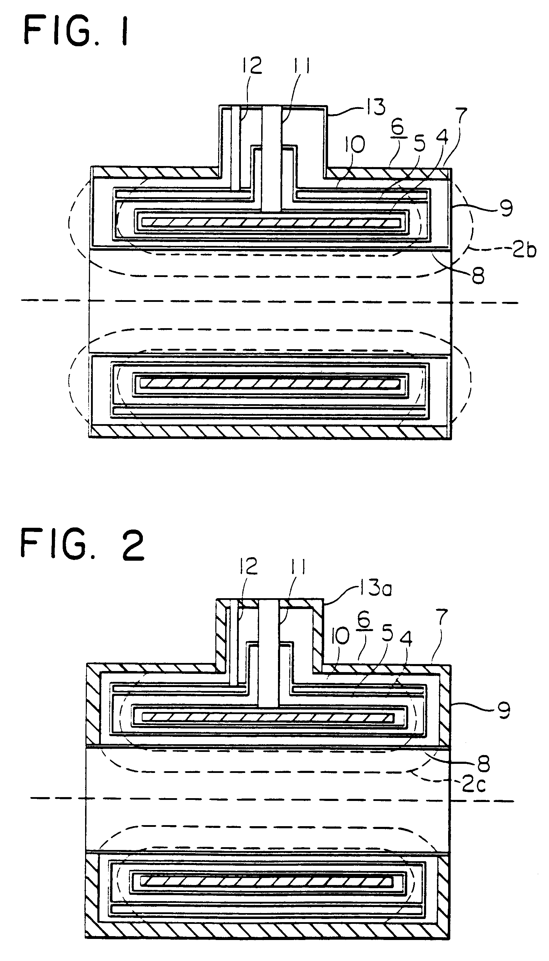

Referring to Fig. 1, numeral 4 designates a superconducting coil which is constructed by winding a superconducting wire. A liquid helium tank 5 receives the superconducting coil 4, and contains a cryogen such as liquid helium for cooling the superconducting coil 4. Numeral 6 generally designates a vacuum heat insulation vessel which receives the liquid helium tank 5, and has its interior evacuated for heat insulation.

An outer cylinder 7 lies at the outer peripheral part of the vacuum heat insulation vessel 6 and is made of a ferromagnetic material of high permeability having a thickness sufficient to exhibit a magnetic shield effect. An inner cylinder 8 forms the inner periphery of the vacuum heat insulation vessel 6. Flanges 9 correspond to the end parts of the vacuum heat insulation vessel 6. Shown at numeral 10 is a thermal shield which lies between the liquid helium tank 5 and the vacuum heat insulation vessel 6, and which surrounds the liquid helium tank 5. This thermal shield 10 is mounted for the purpose of reducing the quantity of heat to enter the liquid helium tank 5, and it is cooled by liquid nitrogen. A communication pipe 11 holds the liquid helium tank 5 and the exterior of the vessel 6 in communication, while a communication pipe 12 holds the thermal shield 10 and the exterior of the vessel 6 in communication. In order to lengthen the communication pipes and to set sufficient heat insulation distances, a projection 13 is provided. Magnetic fluxes 2b are generated by the superconducting coil 4.

In the superconducting magnet constructed as shown in Fig. 1, the magnetic fluxes 2b are generated so as to interlink with the superconducting coil 4 when conducting current through this coil. Most of the magnetic fluxes 2b extend along the inner periphery of the superconducting coil 4, and some of them traverse the superconducting coil 4, whereupon they extend along the outer periphery of the superconducting coil 4. Outside the outer periphery of the superconducting coil 4, most of the magnetic fluxes pass through the outer cylinder 7 of the vacuum heat insulation vessel 6 having the function of the magnetic shield, and they return inside the superconducting coil 4. Thus, the magnetic fluxes 2b form loops.

Accordingly, the magnetic fluxes generated by the superconducting coil 4 do not spread much beyond the outer periphery of the outer cylinder 7, whereby the intensity of the magnetic field outside the outer periphery of the superconducting magnet can be suppressed. At the same time, the vacuum heat insulation vessel 6 required in a superconducting magnet is formed.

While the above superconducting magnet has been illustrated as to the case where only the outer cylinder 7 of the vacuum heat insulation vessel 6 is made of the ferromagnetic substance, similar effects are produced when flanges 9 and a projection 13 are also made of the ferromagnetic substance as shown in Fig. 2. In Fig. 2, symbol 2c denotes magnetic fluxes generated by the superconducting coil 4. Since the other portions are identical or equivalent to those in Fig. 1, the description thereof will be omitted.

In addition, when the superconducting coil 4 is arranged concentrically with the outer cylinder 7 and flanges 9 of the vacuum heat insulation vessel 6, the magnetic shield is endowed with a symmetry to the magnetic field inside the superconducting coil 4. Accordingly, no influences on the magnetic field inside the superconducting coil 4 occur, and influences thereon are low in case a high degree of uniformity in the magnetic field inside the superconducting coil 4 is required.

As described above, the vacuum heat insulation vessel of a superconducting magnet has a part thereof, principally its outer cylinder, made of a ferromagnetic substance having a magnetic shield effect. This alleviates the need to have additional components act as a magnetic shield outside the superconducting magnet, and brings forth the effect that the device can be rendered small in size and low in cost.

Similar devices can also be found in U.S. patent no. 4 484 814, in particular at column 3 lines 5 to 7. However, although these devices are more economical and cheaper, they are not applicable in those situations where great magnetic symmetry is required. For example, in a magnetic resonance imaging system.

An aim of the present invention is not only to provide a more economical and smaller superconducting magnet than previously known but also one which provides a uniform magnetic field.

According to the present invention there is provided a superconducting magnet which comprises:

a superconducting coil which generates a magnetic field when current is caused to flow therethrough; and

a vacuum heat insulation vessel which serves to receive the coil and to hold it at a cryogenic temperature, wherein the vacuum heat insulation vessel has an outer cylindrical wall made of a ferromagnetic material which exhibits a magnetic shield effect;

characterised in that a communication pipe passes through an end portion of vacuum heat insulation vessel, thereby enabling said outer cylindrical wall to be substantially symmetrically disposed with respect to the superconducting coil.

Brief Description of the Drawings:

Fig. 1 is a sectional view showing a previously proposed superconducting magnet;
Fig. 2 is a sectional view showing another previously proposed superconducting magnet;
Fig. 3 is a sectional view showing an example of a prior art magnet;
Fig 4 is a sectional view of another prior art magnet which is furnished with a magnetic shield;
Fig. 5 is a sectional view showing an embodiment of a superconducting magnet according to the present invention; and
Fig. 6 is a sectional view showing another embodiment. In the drawings, the same symbols indicate identical or corresponding portions.

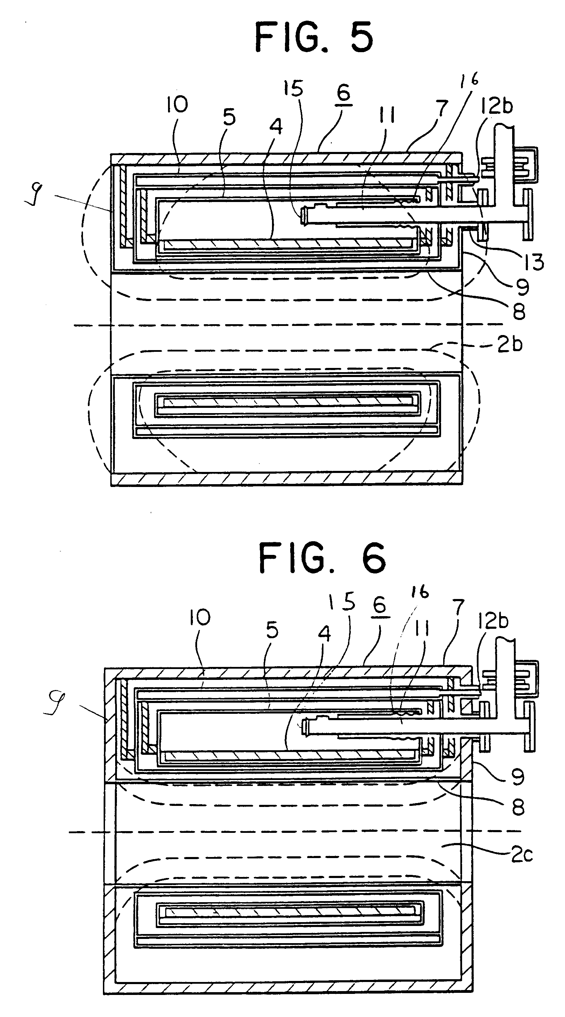

Fig. 5 shows a superconducting magnet embodying the present invention. In this embodiment, a communication pipe 11 passes through the flange 9 instead of through the outer cylinder 7 and is disposed with its longitudinal axis lying substantially horizontally with respect to the axis of the superconducting coil 4. This enables the superconducting magnet to be constructed without a hole perforated through the outer cylinder 7 and without a projection in the side of the outer cylinder 7. The end 15 of the communication pipe 11 is located mid-way along the length of the superconducting coil 4 between the flanges 9. The positioning of the communication pipe 11 as illustrated in Fig. 5 is such as to enable the outer cylinder 7 to be completely symmetrical with respect to the superconducting coil 4. This results in an improvement in the uniformity of the magnetic field around the superconducting magnet.

The embodiment described above is particularly advantageous for a superconducting magnet for a MRI (magnetic resonance imaging system) which needs a uniform magnetic field.

Fig. 6 shows another embodiment of a superconducting magnet in which a communication pipe 11 is disposed substantially horizontally in the same manner as in Fig. 5. In this embodiment, the flanges 9 are formed of ferromagnetic material having sufficient thickness to provide a magnetic shielding effect. Thus, the communication pipe 11 passes through a hole in the flange 9. This embodiment has the advantages of the symmetrical outer cylinder 7 described with reference to Fig. 5, but the magnetic shielding performance is further improved due to the presence of the flanges 9.

In the embodiments of the present invention, a communication pipe 12b passes from the thermal shield 10 to the exterior of the vessel 6 via the flange 9. Passing the pipe 12b through the flange 9 also enables the outer cylinder 7 to be completely symmetrical.

In both embodiments, the communication pipe 11 is passed through an end wall of the liquid helium tank 5 and a seal is provided between the pipe and the end wall by way of a bellows joint 16. The bellows joint 16 enables the effects of expansion between the pipe and the liquid helium tank 5 to be compensated for in addition to providing the seal.

The communication pipe 11 provides a means whereby gas may be discharged into the atmosphere from the liquid helium tank 5. The communication pipe 11 may also serve to carry and support power leads (not shown) for the superconducting coil 4.

## Claims

1. A superconducting magnet which comprises:

    a superconducting coil (4) which generates a magnetic field when current is caused to flow therethrough; and

    a vacuum heat insulation vessel (6) which serves to receive the coil and to hold it at a cryogenic temperature, wherein the vacuum heat insulation vessel (6) has an outer cylindrical wall (7) made of a ferromagnetic material which exhibits a magnetic shield effect;

    characterised in that a communication pipe (11) passes through an end portion (9) of vacuum heat insulation vessel (6), thereby enabling said outer cylindrical wall (7) to be substantially symmetrically disposed with respect to the superconducting coil (4).

2. A superconducting magnet as defined in claim 1, in which both end portions (9) of said vacuum heat insulation vessel (6) are continuous to said outer cylinder portion and are made of the ferromagnetic material to exhibit the magnetic shield effect.

3. A superconducting magnet as claimed in either claim 1 or 2, in which an end (15) of said communication pipe (11) is disposed mid-way along the length of said superconducting coil between said end portions.

4. A superconducting magnet as claimed in any one of claims 1 to 3, further comprising a bellows joint (16) to provide a seal between the communication pipe (11) and the end portion (9).

5. A superconducting magnet as claimed in claim 4 when dependent on claim 3, comprising a tank (5) for containing a cryogen for cooling the superconducting coil (4), the bellows joint being arranged inside the tank (5) and outside the superconducting coil (4).

## Patentansprüche

1. Supraleitender Magnet, der folgendes aufweist:
    - eine supraleitende Spule (4), die ein Magnetfeld erzeugt, wenn man einen Strom durch sie hindurchfließen läßt; und
    - einen Vakuum-Wärmeisolierbehälter (6), der dazu dient, die Spule aufzunehmen und sie auf einer kryogenen Temperatur zu halten, wobei der Vakuum-Wärmeisolierbehälter (6) eine zylindrische Außenwand (7) hat, die aus einem ferromagnetischen Material besteht, das einen magnetischen Abschirmeffekt zeigt;

    dadurch gekennzeichnet,

    daß ein Verbindungsrohr (11) durch einen Endabschnitt (9) des Vakuum-Wärmeisolierbehälters (6) verläuft, so daß eine im wesentlichen symmetrische Anordnung der zylindrischen Außenwand (7) in bezug auf die supraleitende Spule (4) möglich ist.

2. Supraleitender Magnet nach Anspruch 1, bei dem beide Endabschnitte (9) des Vakuum-Wärmeisolierbehälters (6) durchgehend mit dem äußeren Zylinderbereich ausgebildet sind und aus dem ferromagnetischen Material bestehen, um den magnetischen Abschirmeffekt zu bewirken.

3. Supraleitender Magnet nach Anspruch 1 oder 2, bei dem ein Ende (15) des Verbindungsrohrs (11) in der Mitte entlang der Länge der supraleitenden Spule zwischen den Endabschnitten angeordnet ist.

4. Supraleitender Magnet nach einem der Ansprüche 1 bis 3, der ferner eine Balgenverbindung (16) aufweist, um eine Abdichtung zwischen dem Verbindungsrohr (11) und dem Endabschnitt (9) zu bilden.

**5.** Supraleitender Magnet nach Anspruch 4, wenn dieser auf Anspruch 3 rückbezogen ist, wobei der Magnet einen Behälter (5) aufweist, um ein Kältemittel zum Kühlen der supraleitenden Spule (4) aufzunehmen, wobei die Balgenverbindung innerhalb des Behälters (5) und außerhalb der supraleitenden Spule (4) angeordnet ist.

**Revendications**

**1.** Un aimant supraconducteur comprenant:

une bobine supraconductrice (4) engendrant un champ magnétique lorsqu'elle est traversée par du courant; et

une cuve d'isolation thermique sous vide (6) servant à recevoir la bobine et à la maintenir à une température cryogénique, la cuve d'isolation thermique sous vide (6) comportant une paroi cylindrique externe (7) faite en un matériau ferromagnétique présentant un effet d'écran magnétique;

caractérisé en ce qu'un tuyau de communication (11) traverse une partie d'extrémité de la cuve d'isolation thermique sous vide (6), permettant ainsi à ladite paroi externe cylindrique (7) d'être agencée de façon pratiquement symétrique par rapport à la bobine supraconductrice (4).

**2.** Un aimant supraconducteur selon la revendication 1, dans lequel les deux parties d'extrémité (9) de ladite cuve d'isolation thermique sous vide (6) sont continues par rapport à ladite partie cylindrique externe et sont faites dans le matériau ferromagnétique pour présenter l'effet d'écran magnétique.

**3.** Un aimant supraconducteur selon l'une quelconque des revendications 1 ou 2, dans lequel une extrémité (15) du dit tuyau de communication (11) est agencée à mi-distance le long de la longueur de ladite bobine supraconductrice entre lesdites parties d'extrémité.

**4.** Un aimant supraconducteur selon l'une quelconque des revendications 1 à 3, comprenant en outre un joint à soufflet (16) pour assurer l'étanchéité entre le tuyau de communication (11) et la partie d'extrémité.

**5.** Un aimant supraconducteur selon la revendication 4, dans la mesure où celle-ci dépend de la revendication 3, comprenant un réservoir (5) destiné à contenir du cryogène en vue du refroidissement de la bobine supraconductrice (4), le joint à soufflet étant agencé à l'intérieur du réservoir (5) et à l'extérieur de la bobine supraconductrice (4).

# FIG. 1

# FIG. 2

# FIG. 3 PRIOR ART

# FIG. 4 PRIOR ART

# FIG. 5

# FIG. 6